# FASCICULE DE BREVET EUROPEEN

(11) **EP 3 002 521 B1**
(45) Date de publication et mention de la délivrance du brevet: **20.11.2019**
(21) Numéro de dépôt: 15184890.0
(22) Date de dépôt: 11.09.2015
(51) Int. Cl.: F24F 1/02, F24F 1/027, H05K 7/20, F24F 1/0057, H02B 1/56

(54) **SYSTÈME DE REFROIDISSEMENT POUR ARMOIRE ÉLECTRIQUE**
KÜHLSYSTEM FÜR ELEKTRISCHEN SCHALTSCHRANK
COOLING SYSTEM FOR ELECTRICAL ENCLOSURE

(30) Priorité: 29.09.2014 FR 1459166
(43) Date de publication de la demande: 06.04.2016
(73) Titulaire: Schneider Electric Industries SAS, 92500 Rueil-Malmaison (FR)
(72) Inventeur: LOPEZ NIUBO, Josep, 38050 GRENOBLE (FR); PERRIN, Alain, 38050 Grenoble (FR)
(74) Mandataire: Tripodi, Paul

(56) Documents cités:
- DE-A1-102010 042 948
- US-A- 5 199 276
- US-A1- 2007 051 007

## Description

### Domaine technique de l'invention

La présente invention se rapporte à un système de refroidissement destiné à être fixé sur une armoire électrique pour refroidir l'air présent dans ladite armoire.

### Etat de la technique

Une armoire électrique est destinée à recevoir un ou plusieurs appareils électriques. Certains de ces appareils électriques ont la particularité de chauffer et donc de réchauffer l'air environnant. Comme l'armoire électrique est fermée, il est nécessaire de prévoir un système de refroidissement de l'air présent dans l'armoire afin d'éviter toute surchauffe des appareils qui y sont installés.

Selon l'emplacement de l'armoire électrique, le système de refroidissement peut être fixé sur l'armoire électrique à différents endroits. Il peut être fixé sur une face interne d'une paroi latérale de l'armoire électrique, sur la face interne de la paroi inférieure de l'armoire électrique, sur la face opposée à celle du support de fixation qui porte les appareils électriques ou entre le support de fixation des appareils électriques et la paroi supérieure de l'armoire électrique.

Il est difficile de prévoir un système de refroidissement qui puisse s'adapter, sans modification, à ces différentes configurations de positionnement sur une armoire électrique.

Le document US 5 199 276 décrit un système de refroidissement de l'art antérieur.

Le but de l'invention est de proposer un système de refroidissement d'air pour armoire électrique qui peut se fixer à différents emplacements sur l'armoire électrique, sans nécessiter de modifications.

Ce but est atteint par Système de refroidissement pour armoire électrique dans laquelle sont placés un ou plusieurs appareils électriques, comportant :
- un support,
- un module de ventilation fixé sur ledit support et comprenant une entrée d'air agencée pour communiquer avec l'intérieur de l'armoire et une sortie d'air,
- un module condenseur fixé sur ledit support et comprenant un module de refroidissement, une entrée d'air communiquant avec la sortie d'air du module de ventilation pour recevoir l'air aspiré par le module de ventilation, une sortie d'air pour injecter l'air refroidi vers l'intérieur de l'armoire électrique et un conduit d'évacuation de l'eau générée par le refroidissement de l'air par le module de refroidissement,
- le module condenseur comportant un premier boîtier fixé sur le support, le système se caractérise en ce que le module condenseur comporte un deuxième boîtier logé à l'intérieur du premier boîtier et dans lequel débouchent l'entrée d'air et la sortie d'air du module condenseur, et un module de refroidissement logé dans le deuxième boîtier,
- ledit deuxième boîtier est agencé de manière inclinée à l'intérieur du premier boîtier de manière à permettre un écoulement de l'eau généré lors du passage de l'air sur le module de refroidissement quelle que soit la position du système sur l'armoire électrique, et
- le deuxième boîtier comporte deux orifices agencés pour permettre une évacuation d'eau du deuxième boîtier.

Selon l'invention, la sortie d'air du module condenseur est décalée par rapport à l'arête du deuxième boîtier du module condenseur.

Selon une autre particularité, le conduit d'évacuation est intégré au support.

Selon une autre particularité, le système comporte un conduit d'arrivée de fluide frigorigène intégré au support.

### Brève description des figures

D'autres caractéristiques et avantages vont apparaître dans la description détaillée qui suit faite en regard des dessins annexés dans lesquels :
- la figure 1 représente, en vue de côté, le système de refroidissement de l'invention,
- la figure 2 représente le module d'évaporation du système de refroidissement de l'invention,
- les figures 3A à 3E représentent une armoire électrique accueillant, à différents emplacements, le système de refroidissement de l'invention.

### Description détaillée d'au moins un mode de réalisation

De manière connue, une armoire électrique 1 est en règle générale de forme parallélépipédique et comporte une paroi inférieure 11, une paroi supérieure 10 et plusieurs parois latérales 12, l'une des parois latérales formant la porte de l'armoire électrique.

Une armoire électrique est destinée à accueillir un ou plusieurs appareils électriques 2, par exemple de type disjoncteur, contacteur, variateur de vitesse, automate programmable,... En fonctionnement, certains de ces appareils électriques 2 génèrent de la chaleur. Comme l'armoire électrique 1 est fermée, il est nécessaire d'y adjoindre un système de refroidissement 3 en vue de refroidir l'air présent dans l'armoire électrique 1 et éviter ainsi toute surchauffe des appareils électriques 2 qui y sont installés.

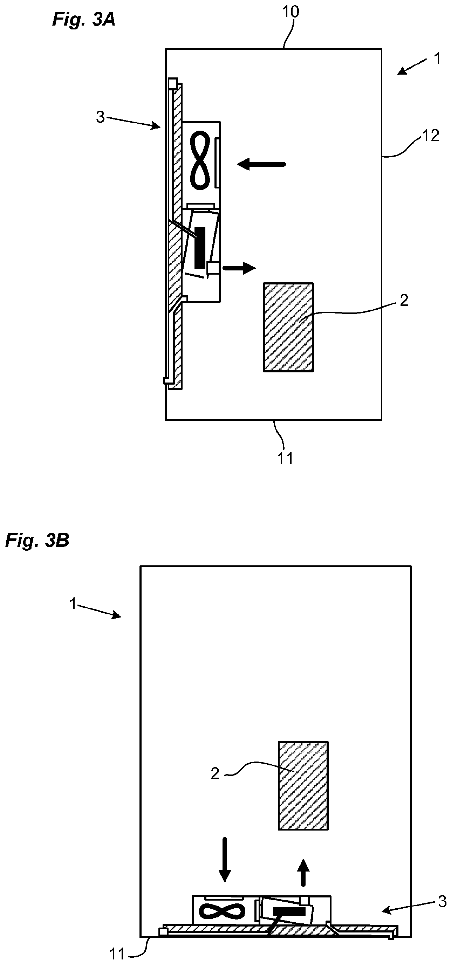

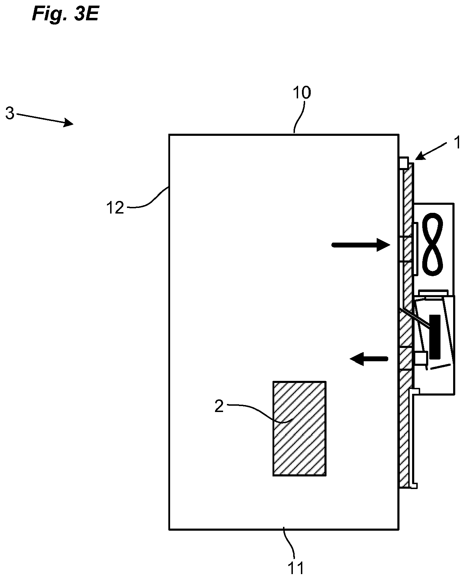

L'invention consiste en un système de refroidissement 3 venant se fixer sur une paroi de l'armoire électrique 1. Le système peut se fixer à l'intérieur ou à l'extérieur de l'armoire électrique. Sur les figures 3A à 3D, le système est montré fixé à l'intérieur de l'armoire électrique 1. Sur la figure 3E, le système est montré fixé à l'extérieur de l'armoire électrique 1.

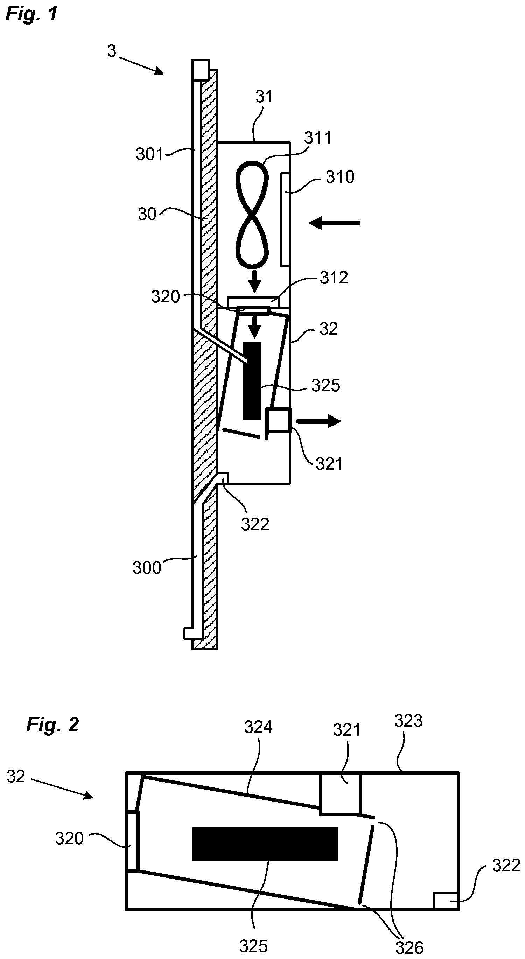

En référence à la figure 1, ce système de refroidissement 3 comporte un support 30 destiné à supporter les éléments nécessaires au refroidissement.

Le système comporte également un module de ventilation 31 comprenant une entrée d'air 310 destinée à communiquer avec l'espace interne de l'armoire, un ventilateur 311 pour aspirer l'air à travers l'entrée d'air et une sortie d'air 312.

Le système comporte un module condenseur 32 comprenant une entrée d'air 320 communiquant avec la sortie d'air 312 du module de ventilation 31, une sortie d'air 321 pour injecter l'air refroidi vers l'intérieur de l'armoire électrique 1 et un conduit d'évacuation 322 de l'eau générée par le refroidissement de l'air par un module de refroidissement.

Le module de ventilation 31 et le module condenseur 32 sont tous les deux fixés sur le support 30.

L'une des particularités du système de l'invention se situe au niveau du module condenseur 32, tel qu'il est représenté sur la figure 2. Ce module condenseur 32 comporte un premier boîtier externe 323 comprenant un plan de fixation par lequel il est fixé sur le support 30 et un deuxième boîtier 324 logé à l'intérieur du premier boîtier 323 et dans lequel est placé un module de refroidissement 325. Ce type de module de refroidissement 324 est bien connu et comporte une structure dans laquelle circule un fluide frigorigène. Cette structure peut être en forme de serpentins, à plaques parallèles,...

Le deuxième boîtier 324 présente la particularité d'être incliné d'un certain angle à l'intérieur du premier boîtier 323 par rapport au plan de fixation du premier boîtier sur le support 30. Quel que soit l'emplacement du système 3 sur l'armoire 1 et l'orientation du module condenseur 32, l'inclinaison du deuxième boîtier 324 permet la collecte et un écoulement de l'eau générée par le refroidissement de l'air.

L'entrée d'air 320 du module condenseur 32 communique avec l'espace interne du deuxième boîtier 324 afin d'amener l'air aspiré par le module de ventilation 31 sur le module de refroidissement 325. La sortie d'air 321 du module condenseur 32 est agencée entre l'espace interne du deuxième boîtier 324 et l'espace interne de l'armoire électrique 1. La sortie d'air 321 est décalée par rapport à l'arête du deuxième boitier 324 pour faire en sorte que le condensat ne soit pas expulsé par la sortie d'air 321 lorsque le système est disposé verticalement.

Le deuxième boitier 324 possède deux orifices 326 positionnés devant les sections d'entrée ou de sortie de l'air pour l'évacuation du condensat.

L'air refroidi par le module de refroidissement 325 est ainsi réinjecté dans l'armoire électrique 1.

L'eau générée par le passage de l'air sur le module de refroidissement 325 s'écoule à l'intérieur du deuxième boîtier 324 du module condenseur 32 et est évacuée hors du module condenseur 32 par le conduit d'évacuation 322. Le support 30 intègre pour sa part un conduit d'évacuation 300 de l'eau communiquant avec celui du module condenseur 32.

Le support 30 intègre également un conduit d'arrivée 301 de fluide frigorigène communiquant avec le module de refroidissement 325.

En référence aux figures 3A à 3C, le système de l'invention peut ainsi être fixé sur l'armoire électrique en différents emplacements, sans modification structurelle. Sur ces figures, le sens de circulation de l'air est indiqué par les flèches.

Sur la figure 3A, le système 3 est fixé sur la face interne d'une paroi latérale 12 de l'armoire.

Sur la figure 3B, le système 3 est fixé sur la face interne de la paroi inférieure 11 de l'armoire électrique.

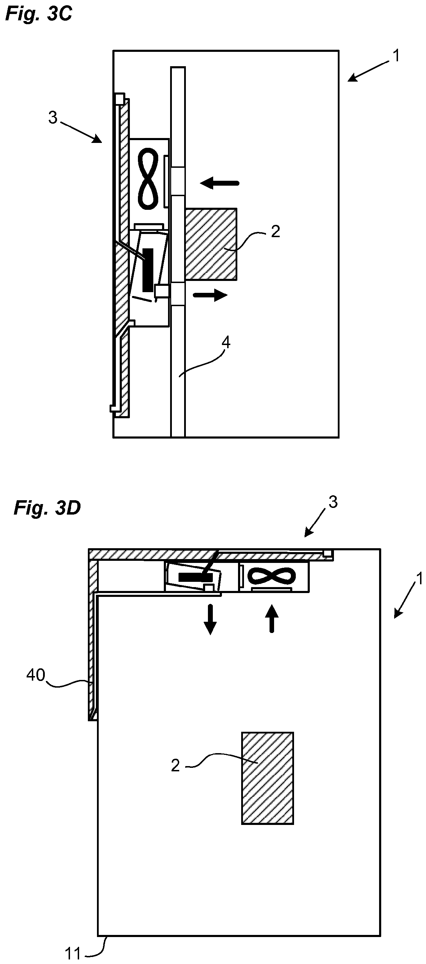

Sur la figure 3C, le système 3 est fixé sur la face opposée à celle de fixation des appareils électriques sur un support 4 positionné dans l'armoire électrique.

Sur la figure 3D, le système 3 est fixé sur la face interne de la paroi supérieure 10 de l'armoire électrique 1. Dans cette situation, le module de ventilation 31 et le module condenseur 32 sont arrangés pour permettre l'évacuation de l'eau issue du module condenseur 32 et un tuyau d'évacuation 40 supplémentaire est ajouté en sortie du module condenseur 32.

Sur la figure 3E, le système est fixé sur la face externe d'une paroi latérale 12 de l'armoire électrique. On voit que l'agencement est identique aux agencements précédents. Dans cette configuration, il est cependant nécessaire de prévoir une ouverture à travers le support pour aspirer l'air dans l'armoire et le réinjecter dans celle-ci.

## Revendications

1. Système de refroidissement (3) pour armoire électrique (1) dans laquelle sont placés un ou plusieurs appareils électriques, ledit système comportant :
- un support (30),
- un module de ventilation (31) fixé sur ledit support et comprenant une entrée d'air (310) agencée pour communiquer avec l'intérieur de l'armoire et une sortie d'air (312),
- un module condenseur (32) fixé sur ledit support et comprenant un module de refroidissement (325), une entrée d'air (320) communiquant avec la sortie d'air (312) du module de ventilation (31) pour recevoir l'air aspiré par le module de ventilation, une sortie d'air (321) pour injecter l'air refroidi vers l'intérieur de l'armoire électrique et un conduit d'évacuation (300) de l'eau générée par le refroidissement de l'air par le module de refroidissement,
- le module condenseur comportant un premier boîtier (323) fixé sur le support (30), **caractérisé en ce que** le module condenseur comporte un deuxième boîtier (324) logé à l'intérieur du premier boîtier (323) et dans lequel débouchent l'entrée d'air et la sortie d'air du module condenseur (32), et un module de refroidissement (325) logé dans le deuxième boîtier,
- ledit deuxième boîtier (324) est agencé de manière inclinée à l'intérieur du premier boîtier (323) de manière à permettre un écoulement de l'eau générée lors du passage de l'air sur le module de refroidissement (325) quelle que soit la position du système sur l'armoire électrique (1), et
- le deuxième boîtier (324) comporte deux orifices (326) agencés pour permettre une évacuation d'eau du deuxième boîtier (324), et
- la sortie d'air (321) du module condenseur (32) est décalée par rapport à l'arête du deuxième boîtier (324) du module condenseur (32).

2. Système selon la revendication 1, **caractérisé en ce que** le conduit d'évacuation (300) est intégré au support (30).

3. Système selon l'une des revendications 1 ou 2, **caractérisé en ce qu'**il comporte un conduit d'arrivée (301) de fluide frigorigène intégré au support (30).

## Patentansprüche

1. Kühlsystem (3) für einen Schaltschrank (1), in dem ein oder mehrere elektrische Geräte angeordnet sind, wobei das System umfasst:
- einen Träger (30),
- ein Lüftungsmodul (31), das an dem Träger befestigt ist und einen Lufteinlass (310), der dazu ausgebildet ist, mit dem Innenraum des Schranks in Verbindung zu stehen, und einen Luftauslass (312) umfasst,
- ein Kondensatormodul (32), das an dem Träger befestigt ist und ein Kühlmodul (325), einen Lufteinlass (320), der mit dem Luftauslass (312) des Lüftungsmoduls (31) in Verbindung steht, um die vom Lüftungsmodul angesaugte Luft aufzunehmen, einen Luftauslass (321), um die gekühlte Luft zum Innenraum des Schaltschranks hin zu blasen, und eine Ablaufleitung (300) für das durch das Kühlen der Luft durch das Kühlmodul erzeugte Wasser umfasst,
- wobei das Kondensatormodul ein erstes Gehäuse (323) umfasst, das an dem Träger (30) befestigt ist, **dadurch gekennzeichnet, dass** das Kondensatormodul ein zweites Gehäuse (324) umfasst, das im Inneren des ersten Gehäuses (323) aufgenommen ist und in das der Lufteinlass und der Luftauslass des Kondensatormoduls (32) münden, und ein Kühlmodul (325), das in dem zweiten Gehäuse aufgenommen ist,
- das zweite Gehäuse (324) im Inneren des ersten Gehäuses (323) geneigt angeordnet ist, so dass es ein Ablaufen des beim Strömen der Luft über das Kühlmodul (325) erzeugten Wassers unabhängig von der Position des Systems am Schaltschrank (1) ermöglicht, und
- das zweite Gehäuse (324) zwei Öffnungen (326) umfasst, die ausgebildet sind, um ein Ablaufen von Wasser aus dem zweiten Gehäuse (324) zu ermöglichen, und
- der Luftauslass (321) des Kondensatormoduls (32) in Bezug auf die Kante des zweiten Gehäuses (324) des Kondensatormoduls (32) versetzt ist.

2. System nach Anspruch 1, **dadurch gekennzeichnet, dass** die Ablaufleitung (300) in den Träger (30) integriert ist.

3. System nach einem der Ansprüche 1 oder 2, **dadurch gekennzeichnet, dass** es eine Zuführleitung (301) für Kältemittel umfasst, die in den Träger (30) integriert ist.

## Claims

1. Cooling system (3) for an electrical enclosure (1) in which one or more electrical units are placed, said system comprising:
- a support (30),
- a ventilation module (31) fixed to said support and comprising an air inlet (310) designed to communicate with the inside of the enclosure and an air outlet (312),
- a condenser module (32) fixed to said support and comprising a cooling module (325), an air inlet (320) communicating with the air outlet (312) of the ventilation module (31) to receive the air drawn in by the ventilation module, an air outlet (321) for injecting the cooled air into the interior of the electrical enclosure, and a discharge duct (300) for removing the water generated by the cooling of the air by the cooling module,
- the condenser module comprising a first casing (323) fixed to the support (30), **characterized in that** the condenser module comprises a second casing (324) housed inside the first casing (323) and into which the air inlet and the air outlet of the condenser module (32) open, and a cooling module (325) housed in the second casing,
- said second casing (324) is arranged at an inclined angle inside the first casing (323) so as to allow the water generated as the air passes over the cooling module (325) to flow regardless of the position of the system on the electrical enclosure (1), and
- the second casing (324) comprises two orifices (326) designed to allow water to be removed from the second casing (324), and
- the air outlet (321) of the condenser module (32) is offset with respect to the corner edge of the second casing (324) of the condenser module (32).

2. System according to Claim 1, **characterized in that** the discharge duct (300) is incorporated into the support (30).

3. System according to one of Claims 1 and 2, **characterized in that** it comprises a refrigerant inlet duct (301) incorporated into the support (30).
